# EUROPEAN PATENT APPLICATION

(11) **EP 2 803 756 A1**
(43) Date of publication of application: **19.11.2014**
(21) Application number: 13075031.8
(22) Date of filing: 13.05.2013
(51) Int. Cl.: C25D 5/10, C25D 5/54, H05K 3/24

(54) **Method for depositing thick copper layers onto sintered materials**

(71) Applicant: Atotech Deutschland GmbH, 10553 Berlin (DE)
(72) Inventor: Gloeden, Markus, 13347 Berlin (DE); Genth, Herko, 13355 Berlin (DE); Dambrowsky, Nina, Dr., 10405 Berlin (DE); McNelly, Antony, 10713 Berlin (DE)
(74) Representative: Wonnemann, Jörg

(57) **Abstract**

The present invention relates to a method for electrodepositing a thick copper layer onto an electrically conductive, sintered layer. The thick copper layer has a high adhesion strength, is poor in defects and internal stress, and has high electrical and thermal conductivity. The thick copper layer on the sintered layer is suited for printed circuit boards for high power electronic applications.

## Description

### Field of the Invention

The present invention relates to a method for electrodepositing a copper layer onto an electrically conductive, sintered layer.

### Background of the Invention

In the manufacturing of printed circuit boards (PCBs) ceramic materials are used as substrates because of its good resistance against high temperatures, its good thermal conductivity, high mechanical stability and its good electrically insulating property. In particular, ceramic substrates are of advantage for high power electronic applications in which the current flow produces high quantities of heat.

A problem in using ceramic substrates for PCBs was to achieve a good adhesion of the conductive metal layers or metallic conductor lines applied onto the ceramic substrate. A number of methods of applying a first thin metal layer as an adhesive layer to the ceramic surface is known. For example thin metal layers were applied to ceramic substrates by vacuum or sputtering methods (US 5,242,535 A), by laminating thin metal foils onto the substrate surface (AT 407 536 B), by sintering metal powder containing pastes on the substrate surface or by wet chemical, electroless metal plating (US 4,888,208 A).

Adhesive layers made of sintered metal powder containing pastes have shown good adhesion to ceramic substrates. European patent application EP 974 565 A1 for example discloses a green sheet of aluminum nitride covered with a paste of tungsten powder and simultaneous sintering to result in an aluminum nitride ceramic substrate with an adhesive tungsten layer thereon. A nickel phosphorous alloy layer was plated onto the tungsten layer and sintered again. The metal layers were further thickened by laminating a copper plate of 1 mm thickness thereon.

Generally, a further metal layer is applied onto the adhesive metal layer in order to generate metal layers with a thickness suitable as conductive paths. These further metal layers of higher thickness can be applied by soldering of thick metal plates or by electroless deposition or electrodeposition of metal (US 4,888,208 A) onto the adhesive metal layer, for example.

Despite the advantage of sintered metal powder containing pastes of providing good adhesion to ceramic substrates, the resulting sintered metal layers have also disadvantages. On the one hand a homogenous alloying is difficult to achieve, in particular in pattern structures. On the other hand a homogenous thickness is difficult to apply over the whole substrate area. In addition, the pastes contain further ingredients like organic compounds, solvents, fluxes, binding material and so on.

During the sintering process these further ingredients cause voids and blisters, and clinkers, further impurities and oxides on the surface of the sintered metal layer.

Therefore in the prior art sintered metal layers are usually at first covered with a thin metal layer by wet chemical electroless deposition methods that compensates the disadvantageous effect of impurities and oxides on the surface of the sintered metal layer.

The clinker, further impurities and oxides impair adhesion of further metal layers and cause defects in further metal layers applied by wet chemical deposition methods. Defects like nodules and whiskers were observed which impair electrical and thermal conductivity. Further defects like liftings occurred that result in no or poor adhesion of the electrodeposited copper layer to the sintered layer.

In particular, in high power electronic applications PCBs are exposed to high thermal stress and therefore a good adhesion of the metal layers to the substrate is a critical factor. Further, high power electronic applications require metal layers and metal circuit paths of high cross section dimension in order to provide good electrical and thermal conductivity. Wet chemical electrodeposition methods are known for this purpose but electrodeposition with typical process parameters has a long process duration which is less economic. The drawback of the long process time can be solved by applying higher current densities. However, high current densities increase the risk of built ins which decreases the purity and the conductivity of the conductive layer. Further advantages of electrodeposition are the possibilities to cover the whole surface of a substrate as a continuous layer or to cover only one or more parts of the substrate surface; and to cover front and back side with metal layers of different thickness.

Besides the disadvantageous effects of a long process time small plating defects occurring initially increase with growing thickness of the metal layer. This becomes visible by increasing roughness of the metal layer converting later on into nodules, whisker and dendrites. The initially small defects that are negligible in metal layers of a thickness below 10 µm simultaneously grow during metal deposition and become particularly pronounced and inacceptable in metal layers of thicknesses above 10 µm.

### Objective of the present Invention

Therefore it is an objective of the present invention to provide a method for direct electrodepositing a metal layer on an electrically conductive, sintered layer, the metal layer having a good adhesion to the sintered layer, a low number of plating defects and a good electrical and thermal conductivity.

### Summary of the Invention

This objective is achieved by a method for electrodepositing at least one copper layer onto an electrically conductive, sintered layer, the method comprising the steps of
(i) providing at least one electrically conductive, sintered layer,
(ii) contacting the sintered layer with an electrolytic copper plating solution and applying an electrical current between the sintered layer and at least one anode, and
(iii) thereby depositing a copper layer onto the sintered layer.

The method of the invention provides copper layers free from defects or poor of defects resulting in high thermal resistance, good electrical and thermal conductivity and good adhesion to the electrically conductive, sintered layer.

The method of the invention may further comprise a step (i.aa) between steps (i) and (ii) wherein the at least one electrically conductive, sintered layer is contacted with a micro etchant. This method step further decreases the number of surface defects and increases the adhesion strength of the deposited copper layer.

The electrolytic copper plating solution may be an acidic solution containing copper ions, chloride ions, sulphuric acid and a low concentration of leveller and a high concentration of carrier. This electrolytic copper plating solution results in deposition of highly pure copper layers with low stress despite of a high thickness.

Step (ii) of the method of the present invention may include using a pulse plating method for depositing copper. Pulse plating further decreases the number of surface defects.

### Brief Description of the Figures

Figure 1: Ceramic substrates with a sintered metal layer electrodeposited with a copper layer by the method of the invention (Figure 1A) and electrodeposited with a copper layer by a prior art method (Figure 1 B).
Figure 2: Scheme of the method steps of the present invention for a sintered layer at least partially covered with a resist.
Figure 3: Scheme of the method steps of the present invention for a sintered layer without a resist.

### Detailed Description of the Invention

The method of the present invention is a method for electrodepositing at least one copper layer onto an electrically conductive, sintered layer, the method comprising the steps of
(i) providing at least one electrically conductive, sintered layer,
(ii) contacting the sintered layer with an electrolytic copper plating solution and applying an electrical current between the sintered layer and at least one anode, and
(iii) thereby depositing a copper layer onto the sintered layer.

The method of the invention provides copper layers free from defects or poor of defects resulting in high thermal resistance, good electrical and thermal conductivity and good adhesion to the electrically conductive, sintered layer. The electrically conductive, sintered layer is abbreviated as the sintered layer herein.

In one embodiment of the method of the invention the at least one electrically conductive, sintered layer is provided on a substrate. The sintered layer is located on the outer surface of the substrate.

The substrate is made of a material having a good thermal resistance and high thermal conductivity. The material of the substrate is thermally resistant against a sintering procedure for example up to a temperature of 1200 °C. Thus, the substrate is also resistant to temperatures applied in a soldering process up to 900 °C, resistant to temperatures up to 500 °C as applied in an annealing process, or resistant to temperatures up to 200 °C in which electronic surface mounted devices are stable.

Thermally resistant means that the substrate is dimensionally stable in the above mentioned temperature range. The substrate is made of a material selected from the group comprising ceramics, glass, enamel, and quartz. Ceramics are selected from electrically insulating materials. Ceramics are selected from the group comprising aluminum oxide, aluminum nitride, silicon nitride, sintered mullite, magnesium oxide, yttrium oxide, aluminum titanium oxide, silicon aluminum oxide nitride, boron nitride, silicon carbide, silicon oxide nitride, beryllium oxide; barium titanate, titania, zirconia, magnesia, calcia, ferrite and mixtures of these compounds.

In one embodiment of the method of the invention the at least one electrically conductive, sintered layer comprises a metal selected from the group of copper, titanium, silver, aluminum, tungsten, silicon, nickel, tin, palladium, platinum, and mixtures thereof. The sintered layer does not contain metals that can diffuse into metallic copper. Otherwise during subsequent deposition of a copper layer an increased number of defects would occur,

The metal of the sintered layer can be applied to the surface of the substrate in form of a paste. The metal is contained in the paste in form of a powder. The paste may further comprise organic compounds, solvents, fluxes, binding material and so on..

The paste can be applied to the substrate by a screen printing method. The paste can be applied to the substrate to cover the whole surface of the substrate as a continuous layer. Or the paste can be applied to cover only one or more parts of the substrate surface. In the latter case the paste can already form a circuit pattern in order to use the substrate with the sintered paste for the manufacture of a PCB.

After applying the paste onto the substrate the paste is sintered at a temperature ranging from 600 °C - 1200 °C, preferably from 700 °C - 1200 °C, more preferably from 800 °C -1100 °C.

The sinter process proceeds in three stages during which the porosity and the volume of the paste significantly decreases. During the first stage the paste merely densifies whereas in the second stage the open porosity of the paste significantly decreases. The mechanical strength of the sintered layer is based on the necks between the powder particles in the paste formed during the third stage by surface diffusion of atoms between the powder particles.

After sintering, the resulting sintered layer has a thickness ranging from 1 µm to 60 µm.

The method according to the invention may further comprise a step (i.a) between steps (i) and (ii):
(i.a) pre-treating the at least one electrically conductive, sintered layer.

The pre-treating of the sintered layer may be a chemical pre-treating. The pre-treating of the sintered layer comprises one or more method steps. The pre-treating of the sintered layer may comprise a step (i.aa) between steps (i) and (ii):
(i.aa) contacting the at least one electrically conductive, sintered layer with a micro etchant.

This method step is also called micro etching step herein. The micro etchant comprises a sulfuric solution. The micro etchant further comprises an oxidizing agent. The sulfuric solution comprises sulfuric acid and/or an alkali metal hydrogensulfate, like sodium or potassium hydrogensulfate. The oxidising agent comprises peroxo compounds. The peroxo compounds are selected from the group comprising hydrogen peroxide, disodium peroxodisulfate, dipotassium peroxodisulfate, ammonium peroxodisulfate, sodium caroate and potassium caroate; preferably disodium peroxodisulfate.

The concentration of sulfuric acid in the micro etchant ranges from 20 - 100 g/l, preferably from 40 - 80 g/I. The concentration of the alkali metal hydrogensulfate in the micro etchant ranges from 10 - 40 g/I. The concentration of the oxidising agent in the micro etchant ranges from 80 - 120 g/I.

The duration of contacting the sintered layer with the micro etchant ranges from 1 minute - 10 minutes, preferably from 1 minute - 8 minutes, more preferably from 1 minute - 5 minutes.

During contacting the sintered layer with the micro etchant the temperature of the micro etchant ranges from 20 °C - 40 °C, preferably from 25 °C - 35 °C, more preferably from 25 °C - 30 °C.

The micro etchant removes oxides that formed during or after the sintering process on the surface of the sintered layer. Contacting the sintered layer with the micro etchant (method step (i.aa)) advantageously decreases the number of surface defects occurring during electrodeposition of copper on the sintered layer in method steps (ii) and (iii). Without method step (i.aa) a higher amount of surface defects occur, like whiskers, nodules, lifting or inhomogenous thickness of the electrodeposited copper layer throughout the surface of the sintered layer. In addition, contacting with the micro etchant increases the adhesion strength of the electrodeposited copper layer to the sintered layer.

In one embodiment of the present invention the contacting of the sintered layer with the micro etchant of method step (i.aa) may be replaced by an alternative method step (i.aa):
(i.aa) contacting the at least one electrically conductive, sintered layer with a micro etchant comprising at least one source of a halogenide ion.

The micro etchant comprising at least one source of a halogenide ion is abbreviated as halogenide solution herein. The halogenide solution may comprise one or more of the components, sulfuric solution and oxidising agent, as described above for the micro etchant. The at least one halogenide ion is selected from the group of fluoride, chloride, bromide and iodide, preferably fluoride, chloride and bromide, more preferably fluoride.

The at least one source of a halogenide ion is selected from the group comprising alkali metal salts, earth alkali metal salts or ammonium salts. The at least one source of a halogenide ion is selected from the group comprising sodium fluoride, potassium fluoride, ammonium hydrogen fluoride (NH₄HF₂), HBF₄, aluminum fluoride (AlF₃), ammonium fluoride (NH₄F), calcium fluoride (CaF₂), tin fluoride (SnF), sodium chloride, potassium chloride, ammonium chloride, lithium chloride (LiCl), caesium chloride (CsCl), magnesium chloride (MgCl₂), calcium chloride (CaCl₂), lead(II) chloride (PbCl₂), iron(II) chloride (FeCl₂), iron(III) chloride (FeCl₃), zink chloride (ZnCl₂), mercury(I) chloride (Hg₂Cl₂), mercury(II) chloride (HgCl₂), barium chloride (BaCl₂), aluminum chloride (AlCl₃), sodium bromide, potassium bromide, ammonium bromide, iron(III) bromide (FeBr₃), lithium bromide (LiBr), magnesium bromide (MgBr₂), rubidium bromide, sodium iodide, potassium iodide, and ammonium iodide, copper(I) iodide, boron triiodide, lithium iodide, magnesium iodide, and calcium iodide; preferably sodium fluoride, potassium fluoride, ammonium hydrogen fluoride (NH₄HF₂), ammonium fluoride (NH₄F), sodium chloride, potassium chloride, ammonium chloride, sodium bromide, potassium bromide, ammonium bromide; more preferably sodium fluoride, potassium fluoride, ammonium hydrogen fluoride (NH₄HF₂), ammonium fluoride (NH₄F).

The concentration of the halogenide ion in the halogenide solution ranges from 0.03 mol/l - 0.4 mol/l, preferably from 0.05 mol/l - 0.3 mol/l, more preferably from 0.1 mol/l - 0.2 mol /l.

The duration of contacting the sintered layer with the halogenide solution and temperature of the halogenide solution during contacting the sintered layer are the same as described above for the micro etchant without a halogenide ion.

Contacting the sintered layer with the halogenide solution results in a further decrease of the number of defects and a further increase in adhesion strength of the electrodeposited copper layer. For example the number of whiskers are reduced to 0 - 1 whisker per unit of sintered layer corresponding to an area of 0.2 dm². Contacting the sintered layer with the halogenide solution is of particular advantage if the sintered layer contains silver, titanium, aluminum and/or silicon.

In one embodiment the pre-treating of the sintered layer of the invention may comprise a further step (i.ab) between steps (i) and (i.aa):
(i.ab) contacting the at least one electrically conductive, sintered layer with an alkaline cleaner.

The alkaline cleaner is an aqueous solution containing an alkali metal hydroxide, like potassium hydroxide; an alkali metal silicate, like sodium silicate; and one or more surfactants.

The alkaline cleaner removes organic impurities like finger prints, fats or oils; and clinker resulting from the sintering process.

The duration of contacting the sintered layer with the alkaline cleaner ranges from 0.1 minute - 10 minutes, preferably from 0.5 minutes - 8 minutes, more preferably from 0.5 minutes - 5 minutes.

During contacting the sintered layer with the alkaline cleaner the temperature of the alkaline cleaner ranges from 40 °C - 70 °C, preferably from 45 °C - 65 °C, more preferably from 50 °C - 60 °C.

In one embodiment the pre-treating of the sintered layer of the invention may comprise a further step (i.ac):
(i.ac) contacting the at least one electrically conductive, sintered layer with an acidic cleaner.

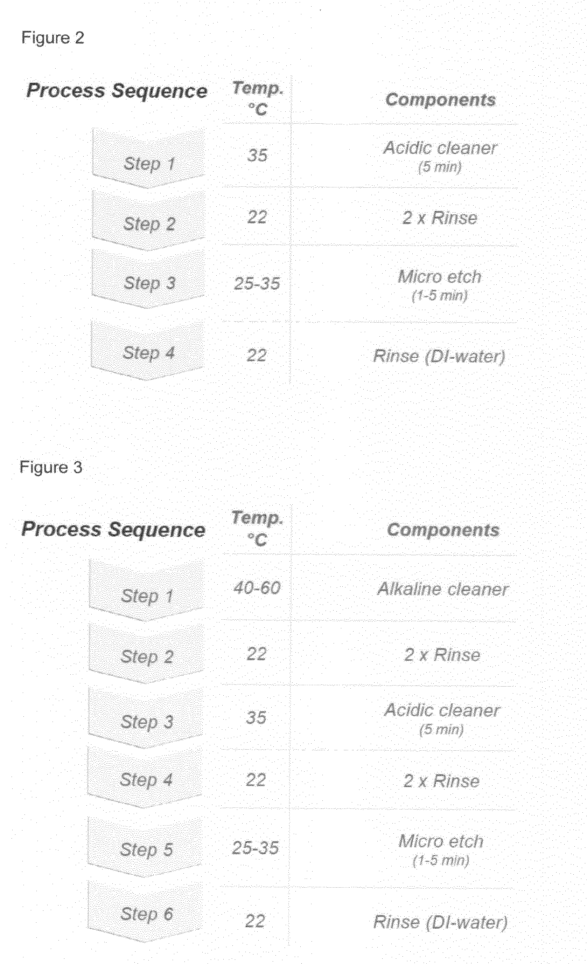

Method step (i.ac) may be performed instead of step (i.ab) or in addition to step . (i.ab). If method step (i.ac) is performed instead of step (i.ab), step (i.ac) is performed between step (i) and step (i.aa) as shown in figure 2. If method step (i.ac) is performed in addition to step (i.ab) ), step (i.ac) is performed between step (i.ab) and step (i.aa) as shown in figure 3.

The acidic cleaner is an aqueous solution containing an inorganic acid, such like sulfuric acid, phosphoric acid or nitric acid; an organic acid, such like carboxylic acids which are complex forming with metal ions, for example formic acid, acetic acid or citric acid; and one or more surfactants, such like a nonionic wetting agent, for example an alkoxylated fatty alcohol. The acidic cleaner removes oxides, preferably oxides of the metals in the sintering layer.

The duration of contacting the sintered layer with the acidic cleaner ranges from 1 minute - 10 minutes, preferably from 2 minutes - 8 minutes, more preferably from 4 minutes - 6 minutes.

During contacting the sintered layer with the acidic cleaner the temperature of the acidic cleaner ranges from 20 °C - 50 °C, preferably from 25 °C - 45 °C, more preferably from 30 °C - 42 °C, most preferably from 30 °C - 38 °C.

Subsequently to method steps (i.ab) and (i.ac) one or more rinsing steps may be performed with water at room temperature, ranging from 18 °C - 25 °C.

Subsequently to method step (i.aa) one or more rinsing steps may be performed with deionized water at room temperature, ranging from 18 °C - 25 °C.

The method according to the invention further comprises step (ii):
(ii) contacting the sintered layer with an electrolytic copper plating solution and applying an electrical current between the sintered layer and at least one anode.

Generally, the sintered layer may be covered with copper by an electrodeposition method and an electrolytic copper plating solution already known, like alkaline cyanide or alkaline noncyanide systems, pyrophosphate complex ion systems, or acidic electrolytic copper plating solutions. Acidic electrolytic copper plating solutions are preferred. Of these, acid sulfate and fluoborate copper plating solutions are preferred because of their ability to deposit copper at high current densities. Acid sulfate copper plating solutions are more preferred because they are less expensive and easier to control.

The electrolytic copper plating solution of the present invention may be an acidic copper plating solution. The electrolytic copper plating solution comprises an inorganic matrix comprising copper(II) ions, chloride ions and an acid.

Copper(II) ions can be given into the electrolytic copper plating solution as copper sulfate pentahydrate (CuSO₄ x 5H20) or as copper sulfate solution. The working range is between 15 - 75 g/l copper(II) ions.

The acid is selected from the group comprising sulfuric acid, methane sulfonic acid and fluoroboric acid (HBF₄), preferably sulfuric acid and methane sulfonic acid, more preferably sulfuric acid. Sulfuric acid (H₂SO₄) is added as 50 - 96% by weight solution. The working range for the acids is between 20 - 400 g/l, preferably 150 - 300 g/l.

Chloride ions are added as sodium chloride (NaCl) or as hydrochloric acid solution (HCl). Here, the working range of chloride ions is between 20 - 200 mg/l, preferably 70 - 120 mg/l.

The electrolytic copper plating solution may further comprise organic additives. The organic additives are selected from the group of brightening agents, leveling agents, carriers, wetting agents and mixtures thereof.

Usually, wetting agents are oxygen-containing, high-molecular compounds in concentrations of 0.005 - 20 g/l, preferably 0.01 - 5 g/l. Examples are given in Table 1.

| **Table 1** |
|---|
| **Wetting agent** |
| Carboxymethylcellulose |
| * Nonylphenolpolyglycolether |
| * Octandiol-bis-(polyalkylene glycol ether) |
| * Octanol polyalkylene glycol ether |
| * Oleic acid polyglycol ester |
| * Polyethylene glycol-polypropylene glycol copolymerisate |
| * Polyethylene glycol |
| * Polyethylene glycol dimethylether |
| * Polypropylene glycol |
| Polyvinylalcohol |
| * ß-naphthyl polyglycolether |
| Stearic acid polyglycol ester |
| Stearic acid alcohol polyglykolether |

As carriers polyalkylene glycol polymers with molecular weights above 3000 g/mol can be used. Preferably the molecular weight ranges from 3000 - 6000 g/mol. Preferred are ethylene oxide-propylene oxide block copolymers. In addition to acting as carriers, carriers also act as wetting agents. The compounds listed in table 1 and marked with an asterisk are also examples of carriers. The concentrations of the carriers used are above 0.1 g/I. Preferably the concentrations of the carriers range from 0.1 g/l - 3 g/I, more preferably from 0.2 g/l - 2 g/l, even more preferably from 0.3 g/l - 2 g/I.

If carriers are used within the electrodeposition method of the present invention and the electrolytic copper plating solution, the deposited copper layers are highly pure. Highly pure means herein the deposit contains a copper amount ranging from 98 % - 100% by weight, preferably 99 % - 99.95 %, more preferably from 99.85 % - 99.95 % by weight.

In addition, using the preferred carriers results in deposited copper layers of low stress. This is particularly of advantage in the case of copper layers with a thickness of 100 µm and higher, because the deposited copper layers are of low stress despite their high thickness. Low stress means herein an internal stress below 250 MPa, preferably between 50 MPa and 100 MPa, more preferably between 10 MPa and 50 MPa.

In general, as brightening agents sulfur-containing substances are used which are listed in Table 2.

| **Table 2** |
|---|
| **Sulfur compounds** |
| 3-(Benzothiazolyl-2-thio)-propyl sulfonic acid, sodium salt |
| 3-Mercaptopropane-1-sulfonic acid, sodium salt |
| Ethylene dithiodipropyl sulfonic acid, sodium salt |
| Bis-(p-sulfophenyl)-disulfide, disodium salt |
| Bis-(ω-sulfobutyl)-disulfide, disodium salt |
| Bis-(ω-sulfohydroxypropyl)-disulfide, disodium salt |
| Bis-(ω-sulfopropyl)-disulfide, disodium salt |
| Bis-(ω-sulfopropyl)-sulfide, disodium salt |
| Methyl-(ω-sulfopropyl)-disulfide, disodium salt |
| Methyl-(ω-sulfopropyl)-trisulfide, disodium salt |
| O-ethyldithio-carbonic acid-S-(ω-sulfopropyl)-ester, potassium salt |
| Thioglycolic acid |
| Thiophosphoric acid-O-ethyl-bis-(ω-sulfopropyl)-ester, disodium salt |
| Thiophosphoric acid-(ω-sulfopropyl)-ester, trisodium salt |

The concentrations of the brightening agents used are in a range from 0.1 - 100 mg/l.

As leveling agents polymeric nitrogen compounds (e.g. polyamines or polyamides) or nitrogen-containing sulfur compounds, such as thiourea derivatives; or lactam alkoxylates; as described in DE 38 36 521 C2 can be used. Preferred leveling agents are polymeric nitrogen compounds, more preferred are polyamides, even more preferred are polymeric lactam alkoxylates. The leveling agents used within the electrodeposition method of the present invention and the electrolytic copper plating solution, cause deposited copper layers of high purity, a low number of surface defects and high electrical and thermal conductivity.

The concentrations of the leveling agents used are in a range from 0.1 - 100 mg/l, preferably range from 0.1 - 50 mg/l, more preferably from 1 - 20 mg/l, even more preferably from 1 - 5 mg/l.

In a preferred embodiment the electrolytic copper plating solution contains a low concentration of leveller and a high concentration of carrier. The low concentration of the leveller ranges from 1 - 5 mg/l and the high concentration of the carrier ranges from 0.2 - 2 g/l.

The combination of a low concentration of leveller and a high concentration of carrier further increases the purity of the deposited copper layer and further decreases the internal stress. In addition, the high purity of the deposited copper layer further increases the electrical conductivity of the copper. A low internal stress of the deposited copper layers is of advantage because it further increases the adhesion strength between the sintered layer and the electrodeposited copper layer.

The copper (II) ions deplete in the electrolytic copper plating solution during electrodepositing copper onto the sintered layer. Therefore copper (II) ions have to be replenished during the electrodeposition process. In one embodiment of the present invention replenishing copper (II) ions may be accomplished by adding copper (II) oxide (CuO) and/or copper (II) carbonate. This is of advantage if inert anodes are used for electrodeposition of copper on the sintered layer.

In the method of the present invention the sintered layer is electrically connected as cathode and contacted with the electrolytic copper plating solution and an electrical current is applied between the sintered layer and at least one anode. The current is either a direct current, an alternating current or a pulsed current.

In one embodiment of the present invention the applied current has an average current density higher than 3 A/dm², preferably ranging from 3 A/dm² - 20 A/dm², more preferably ranging from 3 A/dm² - 15 A/dm². If a direct current is applied between the sintered layer and an anode the average current density corresponds to the applied direct current density. If an alternating or pulsed current is applied the average current density is defined as described by Chandrasekar et al. (M.S. Chandrasekar, Malathy Pushpavanam; Pulse and pulse reverse plating - Conceptual advantages and applications; Electrochimica Acta 53 (2008) 3313-3322; Chapter 5).

With the electrolytic copper plating solution and the electrodeposition method according to the invention it is possible to deposit copper layers on sintered layers with a high current density ranging from 3 A/dm² - 15 A/dm² and the copper layers have a low number of surface defects and a low stress despite deposition at high currents.

Direct current, abbreviated as DC, is an electric charge flowing constantly in only one direction. The electrodeposition of copper onto the sintered layer according to the invention may be performed at direct current at a current density ranging from 1 A/dm² - 15 A/dm², preferably from 2 A/dm² - 10 A/dm², more preferably from 3 A/dm² - 7 A/dm².

Alternating current, abbreviated as AC, is an electric charge flow periodically reversing its direction.

Pulsed current is used in pulse electrodeposition, abbreviated as PED, in which the voltage or current is alternated swiftly between two different values. This results in a series of pulses of equal or different amplitude, duration and polarity. The applied current waveform can be divided into two groups: (1) unipolar waveforms and (2) bipolar waveforms.

In unipolar waveforms are all the current pulses in one direction. All the current pulses have the same polarity. All the current pulses are forward pulses (cathodic pulses) or all the current pulses are reverse pulses (anodic pulses). A pulse may be followed by a pulse of higher or lower amplitude or a pulse may be followed by a period without current (zero current), also called a pulse pause herein. Pulses are combined in cycles and in every cycle at least one forward current pulse occurs. Alternatively in every cycle at least two forward current pulses occur. Alternatively in every cycle at least one forward current pulse occurs and at least one pulse pause.

In the present invention pulse electrodeposition is preferred, more preferred is pulse electrodeposition with unipolar waveforms, even more preferred is pulse electrodeposition with unipolar waveforms in which in every cycle at least one forward current pulse occurs, most preferred is pulse electrodeposition with unipolar waveforms in which in every cycle at least one forward current pulse occurs and at least one pulse pause.

Depositing copper onto the sintered layers by pulse electrodeposition advantageously results in a significant decrease of the number of defects and the stress in the electrodeposited copper layer. This effect is further pronounced when copper is deposited by pulse electrodeposition with a unipolar waveform in which the cycles contain a forward current pulse and a pulse pause.

The current densities of the forward current pulses range from 3 A/dm² - 20 A/dm².

The duration of the forward current pulses ranges from 20 ms - 300 ms.

The duration of the pulse pauses ranges from 0.5 ms - 100 ms.

In bipolar waveforms reverse (anodic) and forward (cathodic) pulses are mixed. A pulse of one polarity (forward or reverse) may be followed by a pulse of opposite polarity. This is called pulse reverse current technique, abbreviated as PRC. In addition, a pulse may be followed by a pulse pause. The pulse reverse current is supplied in cycles and in every cycle at least one forward current pulse and at least one reverse current pulse occur. Alternatively in every cycle at least one forward current pulse, at least one reverse current pulse and at least one pulse pause occur.

Anodes suited for electrodeposition of copper on the sintered layer according to the invention may be soluble or inert anodes known in the art. If the deposition is performed at current densities of 4 A/dm² or higher inert anodes are preferred. Using inert anodes has the advantage that the electrodeposition can be performed at higher current densities requiring shorter plating times and resulting in a better surface distribution.

The plating time depends on the current density applied in the electrodeposition method of the present invention and on the desired thickness of the copper layer electrodeposited onto the sintered layer. For example at 3 A/dm² electrodeposition is performed for 7.5 hours to yield a copper layer of 300 µm thickness and at 10 A/dm² electrodeposition is performed for 2.3 hours to yield a copper layer of 300 µm thickness.

The process temperature, which means the temperature of the electrolytic copper plating solution during deposition, ranges from 15 °C - 60 °C, preferably 15 °C - 50 °C, more preferably from 20 °C - 40 °C, even more preferably from 20 °C - 30 °C, most preferably from 22 °C - 25 °C.

During electrodeposition of copper onto the sintered layer the electrolytic copper plating solution may be agitated. Electrolyte agitation can be performed by air agitation, by a sparger, by an eductor, by spraying the electrolyte onto the sintered layer or by panel movement (also called flightbar movement), preferably by a sparger and/or panel movement. If a sparger is used in combination with panel movement, the panel movement (in this case also called knife movement) is performed in an angle of 90° in relation to the direction of the sparger flow.

In a preferred embodiment of the method of the present invention the sintered metal layer is inserted into the electrolytic copper plating solution while the electric current is already applied between the sintered layer and the anode. As a preferred alternative the sintered metal layer is inserted into the electrolytic copper plating solution when the current is still switched off. In this case the current is applied between the sintered layer and the anode within a very short time after inserting the sintered layer into the electrolyte. A very short time means here a time ranging from 1 second - 2 seconds. This embodiment results in a further increase in adhesion strength between the electrodeposited copper layer and the sintered layer and further decreases the number of defects within the electrodeposited copper layer.

In one embodiment the method of the invention may comprise a further step (ii.a) between steps (i.a) and (ii):
(ii.a) contacting the sintered layer with the electrolytic copper plating solution and applying an electrical current between the sintered layer and at least one anode for a shorter time period than in method step (ii).

Step (ii.a) is also called a pre-plating step herein. The shorter time period of the pre-plating step means a time ranging from 1 - 10 minutes, preferably from 4 - 6 minutes. The pre-plating step is performed in the same electrolytic copper plating solution, with the same anodes and at the same temperature as step (ii). The pre-plating step is performed using direct current at a low current density ranging from 0.5 - 2 A/dm². The thickness of the copper layer resulting from the pre-plating step ranges between 0.1 and 3 µm, preferably between 0.5 and 1.5 µm.This method step advantageously enhances smoothness of the surface to be plated by subsequent method step (ii) and further increases adhesion of the copper layer electrodeposited during method step (ii).

The method of the present invention may be performed in a batch setup or in a conveyor line setup (horizontal or vertical ), preferably in a batch setup.

In one embodiment the method of the invention may comprise a further step (iii.a) after step (iii):
(iii.a) storing the sintered layer with the deposited copper layer thereon at a temperature ranging from 200 °C - 500 °C.

Step (iii.a) is also called an annealing step herein. The annealing step is performed during a time period ranging from 10 minutes - 400 minutes. Advantageously the annealing step results in an increase in ductility, a further decrease of the internal stress of the electrodeposited copper layer and a further increase in adhesion strength between the electrodeposited copper layer and the sintered layer.

With the method according to the invention thick copper layers can be electrodeposited onto the sintered layer. The thick copper layers have a thickness ranging from 100 µm - 600 µm, preferable from above 100 µm - 600 µm, more preferably from 150 µm - 600 µm, even more preferably from 200 µm - 400 µm, most preferably from 200 µm - 300 µm.

The copper layer can be electrodeposited onto the sintered layer to cover the whole surface of the sintered layer as a continuous layer. Or the copper layer can be electrodeposited to cover only one or more parts of the surface of the sintered layer

In further embodiments the method of the invention may comprise further steps in order to generate two-dimensional copper structures on the surface of the sintered layer. Preferably the two-dimensional copper structures are circuit patterns.

In one embodiment of the method of the invention the paste containing metal powder is already applied to the surface of the substrate in the form of a circuit pattern. After sintering of the paste, copper is electrodeposited by the method of the present invention onto the sintered pattern. Therefore the electrodeposited copper already displays the circuit pattern.

In a further embodiment of the method of the invention the electrically conductive, sintered layer covers the whole surface of the substrate as a continuous layer.

In a further embodiment of the method of the invention the electrically conductive, sintered layer covers the whole surface of the substrate as a continuous layer and the electrodeposited copper layer covers the whole surface of the sintered layer as a continuous layer.

In the latter two embodiments the copper circuit pattern is formed by conventional techniques such as are known in the art for fabricating a printed circuit. A printed circuit is produced by an etching process in which the copper is etched in a pattern corresponding to the desired electrical pathways of the circuit. In forming the printed circuit, a mask of resist is applied to the sintered layer or the electrodeposited copper layer by silk screen printing. The substrate with sintered layer and if applicable the electrodeposited copper layer are then immersed in a bath of etching solution, generally an aqueous solution of hydrochloric acid. After a suitable time, copper and sintered layer are removed by the hydrochloric acid in the unmasked areas down to the substrate to produce a copper circuit pattern. Conventional techniques for fabricating a printed circuit include subtractive methods, semi-additive methods and full-additive methods.

In a further embodiment of the method of the invention the electrically conductive, sintered layer covers the whole surface of the substrate as a continuous layer and a mask of resist is applied onto the sintered layer. Afterwards method steps (ii) and (iii) are performed. Further optional method steps may be performed, but method step (i.ab) is excluded. In this embodiment method step (i.ab), the contacting of the sintered layer with an alkaline cleaner, will not be performed as shown in figure 2.

In a further embodiment of the method of the invention the electrically conductive, sintered layer is not covered by a mask of resist. In this embodiment method steps (ii) and (iii) are performed and all further optional method steps may be performed, including method step (i.ab) as shown in figure 3.

With the method of the invention it is possible to electrodeposit copper layers onto an electrically conductive, sintered layer and the copper layers have an excellent adhesion to the sintered layer. In a peel test, which is known to be used to test adhesion strength, it is nearly impossible to separate the electrolytically deposited copper layer from the subjacent sintered layer. Rather the substrate breaks than the copper layer detaches from the sintered layer.

With the method of the invention it is further possible to electrodeposit copper layers onto an electrically conductive, sintered layer and the copper layers have a high thickness ranging from 100 µm to 600 µm and are highly pure. The electrodeposited copper layers have a low number of defects, which means the copper layers are nearly free of defects. The electrodeposited copper layers have low internal stress, which means the copper layers are poor in internal stress and nearly free of internal stress. These properties impart a very high electrical conductivity as well as very high thermal conductivity to the electrodeposited copper layer. In addition, low internal stress of the copper layer has the advantage to prevent occurrence of warpage or cracks in the substrate.

With the method of the invention it is further possible to electrodeposit copper layers onto an electrically conductive, sintered layer and the copper layers have a high ductility, a low surface roughness and a uniform thickness distribution.

Because of their very high electrical conductivity and very high thermal conductivity, the copper layers electrodeposited onto sintered layers by the method of the present invention are particularly suited for high power electronic applications, especially for printed circuit boards for high power electronic applications.

### Example

A ceramic substrate made of aluminum nitride with dimensions of 188 mm in length and 137 mm in width was used in the following example. The substrate was covered with an electrically conductive, sintered layer containing copper, and titanium. The substrate was metallized according to the method of the invention.

Pre-treatment sequence of the substrate:

| Step | Chemistry | Treatment time | Temperature |
|---|---|---|---|
| (i.ac) Acidic cleaner | CupraPro LT1 from Atotech GmbH | 5 min | 35 °C |
| Rinsing | Water | 0.5 min | 22 °C |
| Rinsing | Water | 0.5 min | 22 °C |
| (i.aa) Halogenide solution | Composition see below | 2 min | 25 °C |
| Rinsing | Deionized water | 0.5 min | 22 °C |

Composition of halogenide solution:

| | |
|---|---|
| 100 g/l | Disodium peroxodisulfate |
| 20 g/l | Sodium hydrogensulfate |
| 0.15 mol/l | Sodium fluoride |
| 60 g/l | Sulfuric acid (H₂SO₄) |

After pre-treatment the substrate was subjected to electrodeposition of copper. At first the substrate was pre-plated (corresponds to method step (ii.a)) in an electrolytic copper deposition bath for 5 minutes using direct current at a current density of 1 A/dm². Afterwards the substrate was contacted with the electrolytic copper deposition bath and plated according to the following conditions (corresponds to method step (ii)). The electrolytic copper deposition bath was a conventional acid sulfate copper plating bath containing a leveler, a brightener and a carrier (InPro A200, product of Atotech GmbH).

Plating conditions:
Direct current: Current density: 5.5 A/dm², Current at front side: 70 A, Current at back side: 40 A
Plating time = 165 min.

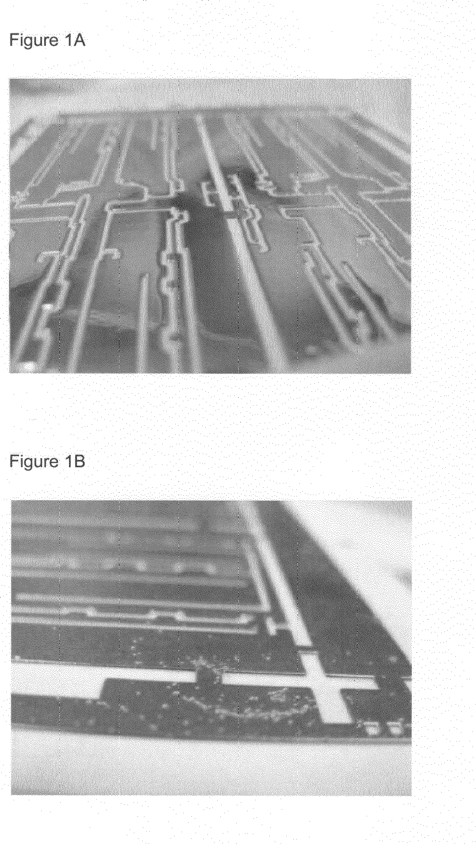

The result of pre-treatment and electroplating of the substrate is shown in Figure 1. The substrate treated according to the invention (Figure 1A) has a bright and smooth deposited copper layer without any defects. An identical substrate treated by a conventional method for pre-treating and electrodepositing copper is shown in Figure 1B. The substrate in Figure 1B has a rough and matte deposited copper layer with a lot of nodules.

## Claims

1. A method for electrodepositing at least one copper layer onto an electrically conductive, sintered layer, the method comprising the steps of
(i) providing at least one electrically conductive, sintered layer,
(ii) contacting the sintered layer with an electrolytic copper plating solution and applying an electrical current between the sintered layer and at least one anode, and
(iii) thereby depositing a copper layer onto the sintered layer.

2. The method according to claim 1 further comprising the step (i.a) between steps (i) and (ii):
(i.a) pre-treating the at least one electrically conductive, sintered layer.

3. The method according to claim 1 or 2 wherein the pre-treating of the sintered layer comprises a step (i.aa) between steps (i) and (ii):
(i.aa) contacting the at least one electrically conductive, sintered layer with a micro etchant comprising a sulfuric solution.

4. The method according to claim 1 or 2 wherein the pre-treating of the sintered layer comprises a step (i.aa) between steps (i) and (ii):
(i.aa) contacting the at least one electrically conductive, sintered layer with a micro etchant comprising at least one source of a halogenide ion.

5. The method according to claim 1 or 2 wherein the at least one electrically conductive, sintered layer comprises a metal selected from the group of copper, titanium, silver, aluminum, tungsten, silicon, nickel, tin, palladium, platinum, and mixtures thereof.

6. The method according to any of the foregoing claims wherein the at least one electrically conductive, sintered layer is provided on a substrate.

7. The method according to claim 4 wherein the substrate is made of a material selected from the group comprising ceramics, glass, enamel, and quartz.

8. The method according to any of the foregoing claims wherein the electrolytic copper plating solution is acidic.

9. The method according to any of the foregoing claims wherein the electrolytic copper plating solution comprises an inorganic matrix comprising copper ions, chloride ions and sulphuric acid.

10. The method according to any of the foregoing claims wherein the electrolytic copper plating solution further comprises organic additives selected from the group of brightening agents, leveling agents, carriers, wetting agents and mixtures thereof.

11. The method according to any of the foregoing claims wherein the electrolytic copper plating solution contains a low concentration of leveller and a high concentration of carrier.

12. The method according to any of the foregoing claims wherein the electrical current is either a direct current, an alternating current or a pulsed current.

13. The method according to any of the foregoing claims wherein the applied electrical current has an average current density higher than 3 A/dm².

14. The method according to any of the foregoing claims wherein the copper layer is a thick copper layer having a thickness ranging from 100-600 µm.
